## Europäisches Patentamt
## European Patent Office
## Office européen des brevets

(19)

(11) Veröffentlichungsnummer: **0 004 014**
**B1**

(12) **EUROPÄISCHE PATENTSCHRIFT**

(45) Veröffentlichungstag der Patentschrift: **30.09.81**

(51) Int. Cl.³: **G 03 F 7/08, G 03 C 5/00**

(21) Anmeldenummer: **79100566.3**

(22) Anmeldetag: **26.02.79**

(54) **Verfahren und Entwicklerlösung zum Entwickeln von belichteten lichtempfindlichen Kopierschichten.**

(30) Priorität: **07.03.78 DE 2809774**

(43) Veröffentlichungstag der Anmeldung:
**19.09.79 Patentblatt 79/19**

(45) Bekanntmachung des Hinweises auf die Patenterteilung:
**30.09.81 Patentblatt 81/39**

(84) Benannte Vertragsstaaten:
**BE DE FR GB IT NL SE**

(56) Entgegenhaltungen:
**DE - A - 2 364 631**
**DE - A - 2 530 502**
**DE - A - 2 624 074**
**DE - A - 2 637 768**
**DE - A - 2 739 774**
**FR - A - 1 551 548**
**FR - A - 2 366 598**

(73) Patentinhaber: **HOECHST AKTIENGESELLSCHAFT**
**Postfach 80 03 20**
**D-6230 Frankfurt/Main 80 (DE)**

(72) Erfinder: **Palmer, Roland, Dr. Dipl.-Chem.**
**Freseniusstrasse 53**
**D-6200 Wiesbaden (DE)**

Courier Press, Leamington Spa, England.

# 0 004 014

Verfahren und Entwicklerlösung zum Entwickeln von belichteten lichtempfindlichen Kopierschichten

Die Erfindung betrifft ein Verfahren und eine Entwicklerlösung zum Entwickeln von belichteten lichtempfindlichen Schichten, insbesondere von Flachdruckplatten, die als lichtempfindliche Substanz ein Diazoniumsalz-Polykondensationsprodukt sowie ferner mindestens ein wasserunlösliches harzartiges organisches Polymeres enthalten.

Aus der DE—OS 25 30 502 ist eine für den gleichen Zweck bestimmte Entwicklerlösung bekannt, die ein Puffergemisch aus Alkaliphosphaten und ggf. Phosphorsäure, ein anionisches Netzmittel, ein wasserlösliches Polymeres, insbesondere Dextrin, ggf. ein neutrales Alkalisalz, z.B. Natriumsulfat, und ein mit Wasser mischbares organisches Lösungsmittel enthält und die ein pH im Bereich von 3 bis 11 hat.

Dieser Entwickler ist für die dort beschriebenen Kopierschichten, die Polyvinylacetale als Harze enthalten, gut wirksam. Er hat jedoch geringere Wirkung gegenüber Schichten, die andere Harze, z.B. Polyurethane, enthalten. Ein Nachteil ist auch der verhältnismäßig hohe Gehalt, vorzugsweise 15—40 Gew.-%, an relativ niedrigsiedenden Lösungsmitteln, wie Propanol, der Vorkehrungen zur Beseitigung der Dämpfe erfordert.

Ein ähnlicher Entwickler ist in der DE—OS 26 24 074 beschrieben. Er enthält geringere Mengen und höher siedende Lösungsmittel, z.B. 6% Benzylalkohol, und hat ein pH von 8,5 bis 10,5. Dieser Entwickler kann Polyvinylalkohol enthalten. Er ist speziell für die dort beschriebene Schicht mit ganz bestimmter Zusammensetzung geeignet, für andere Schichten, insbesondere solche mit den wegen ihrer hohen Lichtempfindlichkeit bevorzugten Diazoniumsalz-Mischkondensationsprodukten, wie sie z.B. in der DE—OS 20 24 244 beschrieben sind, ist er weniger geeignet.

Aus der DE—AS 20 34 655 ist ein Entwickler für Schichten mit derartigen Mischkondensationsprodukten bekannt, die außerdem bestimmte modifizierte Epoxyharze enthalten. Dieser Entwickler enthält neben Benzylalkohol, Netzmittel, Salzen und Phosphorsäure auch beträchtliche Mengen (20 Gew.-%) an niedrigsiedendem organischem Lösungsmittel. Er hat auch den Nachteil, daß er sich, vor allem bei maschineller Entwicklung, rasch erschöpft.

In der älteren deutschen Patentanmeldung P27 39 774 ist als Entwickler für Schichten des gleichen Typs, die Polyurethanharze enthalten, eine Lösung von anionischem Netzmittel, Phosphorsäure, Weinsäure, Benzylalkohol und Natriumsulfat beschrieben.

Aufgabe der Erfindung war es, eine wäßrige Entwicklerlösung zum Entwickeln von belichteten lichtempfindlichen Kopierschichten, insbesondere von Flachdruckplatten, die ein Diazoniumsalz-Polykondensationsprodukt und ein wasserunlösliches organisches Polymeres enthalten, bereitzustellen, mit der eine saubere, rückstandsfreie Entwicklung auch von schwierig entwickelbaren Schichten möglich ist, die nur hochsiedende organische Lösungsmittel in relativ kleinen Mengen enthält und die sich bei Anwendung in automatischen Entwicklungsmaschinen nicht rasch erschöpft.

Die Erfindung geht aus von einer Entwicklerlösung gemäß dem Oberbegriff des vorstehenden Patentanspruchs 1.

Die Aufgabe wird erfindungsgemäß gelöst durch eine Entwicklerlösung der im Kennzeichen des Anspruchs 1 angegebenen Zusammensetzung.

Die erfindungsgemäße Entwicklerlösung hat vorzugsweise ein pH von etwa 4 bis 8.

Sie kann zusätzlich Gelatine in einer Menge von 0,01 bis 2, vorzugsweise 0,1 bis 1 Gew.-% enthalten. Der verwendete Polyvinylalkohol soll kein zu hohes Molekulargewicht aufweisen, um die Viskosität der entwicklerlösung nicht zu stark zu erhöhen. Im allgemeinen sind Polyvinylalkohole, deren 4%ige wäßrige Lösungen bei 20°C eine Viskosität von etwa $1 \times 10^{-3}$ bis $2 \times 10^{-2}$ Pa.s (1 bis 20 cP) aufweisen, geeignet, bevorzugt werden Polyvinylalkohole mit Viskositäten von $1 \times 10^{-3}$ bis $1 \times 10^{-2}$ Pa.s (1 bis 10 cP), insbesondere von $1 \times 10^{-3}$ bis $5 \times 10^{-3}$ Pa.s (1 bis 5 cP). Die Viskosität der Entwicklerlösung, die außerdem durch die Konzentration des Polyvinylalkohols und den Gehalt an weiteren Bestandteilen beeinflußt wird, sollte in jedem Fall bei 20°C unterhalb $2 \times 10^{-2}$ Pa.s (20 cP), bevorzugt unterhalb $1 \times 10^{-2}$ Pa.s (10 cP) liegen. Die bevorzugte Konzentration des Polyvinylalkohols liegt im Bereich von 2 bis 4 Gew.-%, die des Polyvinylmethylacetamids zwischen 1 und 4 Gew.-%.

Der bevorzugte Mengenanteil an Benzylalkohol und Glycerintriacetat beträgt jeweils 1—4 Gew.-%.

Außer Benzylalkohol und Glycerintriacetat kann noch ein weiteres, mit Wasser begrenzt mischbares Lösungsmittel mit einem Siedepunkt oberhalb 120°C, bevorzugt oberhalb 150°C, in einer Menge von 0,1 bis 2, vorzugsweise 0,1 bis 0,5 Gew.-% enthalten sein. Geeignet sind höhere Alkohole, insbesondere Cyclohexanol.

Als Puffersubstanzen werden in bekannter Weise Salze starker 'Basen mit schwachen bis mittelstarken Säuren verwendet, insbesondere Alkalisalze von Phosphor- oder Kieselsäure. Die Alkalivor allem die Natriumphosphate werden besonders bevorzugt. Ihre Menge liegt im allgemeinen zwischen 0,5 und 6 Gew.-%, vorzugsweise zwischen 1 und 3 Gew.-%. Besonders bevorzugt werden die sauren Alkaliphosphate. Gegebenenfalls kann auch eine kleine Menge Phosphorsäure zugesetzt werden, um das pH auf den gewünschten Wert zu bringen. Ein Zusatz von Phosphorsäure ist normalerweise erforderlich, wenn als Puffersubstanz Trinatriumphosphat verwendet wird.

2

Es ist zweckmäßig, ein neutrales anorganisches Salz, insbesondere ein Alkalisalz, z.B. Natriumsulfat, in einer Menge bis zu 6 Gew.-%, bevorzugt 1—3 Gew.-%, zuzusetzen, da dadurch die Gradation in erwünschter Weise steiler wird.

Ein Zusatz eines Oxydationsinhibitors, vorzugsweise Hydrochinon, in einer Menge von 0,001 bis 0,1, vorzugsweise 0,005 bis 0,1 Gew.-%, kann erfolgen, um die Lösung beim Stehen an der Luft gegen oxydativen Abbau zu stabilisieren, der sich besonders durch Geruch nach Benzaldehyd zu erkennen gibt.

Als anionisches Netzmittel sind grundsätzlich alle üblicherweise verwendeten Netzmittel dieses Typs geeignet. Gut bewährt haben sich solche, die außer einer langkettigen Alkylgruppe (etwa $C_{12}$—$C_{20}$) und einer Salzgruppe, im allgemeinen einer Alkali- oder Ammoniumsulfonat- oder -sulfatgruppe, noch eine Polyalkylenoxygruppe enthalten. Bevorzugt werden Salze der von Fettalkoholpolyoxyäthylensulfate. Das Netzmittel wird vorzugsweise in einer Menge von 1 bis 10 Gew.-% verwendet.

Der erfindungsgemäße Entwickler hat den Vorteil, daß er trotz niedrigen Gehalts an organischen Lösungsmitteln geeignet ist, auch Schichten aus wasserunlöslichen Diazopolykondensaten und wasserunlöslichen Harzen rückstandsfrei zu entwickeln. Da die Lösung ausschließlich hochsiedende organische Lösungsmittel enthält, bleibt ihre Zusammensetzung auch bei längerem Stehen in offenen Behältern weitgehend konstant, und es ist auch möglich, die Entwicklung ohne nennenswerte Bildung von Lösungsmitteldämpfen bei erhöhter Temperatur durchzuführen, was in vielen Fällen erwünscht ist. Der Entwickler behält als Pufferlösung auch nach längerem Gebrauch den erforderlichen pH-Wert bei, so daß es nicht erforderlich ist, ihn in kurzen Abständen zu ergänzen. Er eignet sich deshalb vor allem zur Verwendung in automatisch arbeitenden Entwicklungsmaschinen. Auch tritt dieser Vorteil besonders in Erscheinung bei der Entwicklung von Schichten, die freie Phosphorsäure enthalten.

Bei Anwendung der erfindungsgemäßen Entwicklerlösung ist normalerweise keine Fixierung oder Konservierung der entwickelten Platte erforderlich, wenn nach beendeter Entwicklung die Platte mit frischer Entwicklerlösung trockengerieben wird.

Der erfindungsgemäße Entwickler eignet sich zur Entwicklung von belichteten lichtempfindlichen Kopiermaterialien, die als lichtempfindliche Substanzen Diazoniumsalz-Kondensationsprodukte und ferner polymere, wasserunlösliche Bindemittel, insbesondere Polyurethane, enthalten. Derartige Materialien sind z.B. in den DE—OS 20 24 244 und 27 39 774 und der DE—PS 12 14 089 beschrieben.

Die folgenden Beispiele erläutern bevorzugte Ausführungsformen der Erfindung. Die Mengen sind in Gewichtsteilen (Gt) angegeben.

Beispiel 1

Eine Lösung von

63,9 Gt eines Polykondensationsprodukts aus 1 Mol 3-Methoxy-diphenylamin-4-diazoniumsalz und 1 Mol 4,4'-Bis-methoxymethyl-diphenyläther, ausgefällt als Mesitylensulfat,

142,0 Gt eines Polyurethans mit 7,0% freien NCO-Gruppen, das durch Umsetzen von 2,4-Tolylendiisocyanat mit einem Gemisch aus Butandiol-(1,4), Polypropylenglykol und Trimethylolpropan erhalten wurde,

99,3 Gt eines Alkydharzes, das durch Polykondensation von 40 Gt Phthalsäureanhydrid, 10 Gt Glycerin und 20 Gt Pentaerythrit sowie 44 Gt einer verzweigten gesättigten Monocarbonsäure hergestellt wurde,

5,6 Gt Phosphorsäure (85%),

6,2 Gt Polyvinylformal,

4,80 Gt Rhodamin 6 GDN extra (C.I. 45 160) und

1,60 Gt Metanilgelb (C.I. 13 065) in

7000 Gt Äthylenglykolmonomethyläther

wurde auf einen Schichtträger aus anodisiertem Aluminium, das mit einer 0,1%igen wäßrigen Lösung von Polyvinylphosphonsäure vorbehandelt worden war, in solcher Dicke aufgebracht, daß die getrocknete Schicht ein Gewicht von 1 g/m² hatte.

Die erhaltene Flachdruckplatte wurde unter einer Vorlage mit einem handelsüblichen Belichtungsgerät von 5 kW Leistung 30 Sekunden belichtet. Sie wurde dann durch Aufgießen einer Lösung von

| 100 | Gt Wasser, |
|---|---|
| 3 | Gt Ammonium-Alkylpolyoxyäthylensulfat (Alkylgruppe mit 18 C-Atomen), |
| 1 | Gt Gelatine, |
| 4 | Gt Polyvinylalkohol (12% Restacetylgruppen, K-Wert 4) |
| 1 | Gt $NaH_2PO_4 \cdot 2H_2O$, |
| 3 | Gt $Na_2So_4 \cdot 10H_2O$, |
| 3 | Gt Benzylalkohol, |
| 2,5 | Gt Glycerintriacetat, |
| 0,02 | Gt Hydrochinon |

innerhalb von etwa einer halben Minute entwickelt. Die Entwicklerlösung hatte den pH-Wert 5,07. Die Platte wurde ohne weitere Behandlung in die Druckmaschine gespannt und lieferte klare, tonfreie Drucke.

Eine handelsübliche Sprühentwicklungsmaschine wurde mit der angegebenen Entwicklerlösung gefüllt und mit Platten der oben angegebenen Zusammensetzung, die das Format 65 x 55 cm hatten, im Durchlauf beschickt. Nachdem 250 Platten entwickelt worden waren, wurde noch kein Nachlassen der Entwicklerwirkung festgestellt. Der pH-Wert war praktisch unverändert.

Beispiel 2

Wie in Beispiel 1 hergestellte und belichtete Flachdruckplatten wurden jeweils mit einer der folgenden Lösungen entwickelt:

| Lösung a) | 100 | Gt Wasser, |
|---|---|---|
| | 3 | Gt Netzmittel wie in Beispiel 1, |
| | 4 | Gt Poly-N-vinyl-N-methylacetamid, |
| | 2 | Gt $Na_2HPO_4$, |
| | 3 | Gt Benzylalkohol, |
| | 3 | Gt Glycerintriacetat, |
| pH = 7,91 | 0,04 | Gt Hydrochinon |

| Lösung b) | 100 | Gt Wasser, |
|---|---|---|
| | 4 | Gt Netzmittel wie in Beispiel 1, |
| | 0,8 | Gt Gelatine, |
| | 4 | Gt Polyvinylalkohol wie in Beispiel 1, |
| | 1 | Gt $Na_2SO_4 \cdot 10H_2O$, |
| | 2 | Gt $NaH_2PO_4 \cdot 2H_2O$, |
| | 2,8 | Gt Benzylalkohol, |
| | 3,2 | Gt Glycerintriacetat, |
| | 0,04 | Gt Hydrochinon, |
| pH = 6,53 | 0,3 | Gt Cyclohexanol |

Lösung c)     100    Gt  Wasser,

                5    Gt  Netzmittel wie in Beispiel 1,

              0,8    Gt  Gelatine,

                4    Gt  Polyvinylalkohol wie in Beispiel 1,

              1,5    Gt  $Na_2SO_4 \cdot 10H_2O$,

              2,0    Gt  $NaH_2PO_4 \cdot 2H_2O$,

              2,8    Gt  Benzylalkohol,

              3,2    Gt  Glycerintriacetat,

             0,04    Gt  Hydrochinon

              0,3    Gt  Cyclohexanol.

Es wurden ähnlich gute Ergebnisse wie in Beispiel 1 erhalten.

Das oben beschriebene Beispiel wurde mit der Abwandlung wiederholt, daß als Schichtträger einmal mechanisch aufgerauhtes und einmal elektrochemisch aufgerauhtes Aluminium verwendet wurde. Die Ergebnisse sind vergleichbar.

Beispiel 3

Eine Lösung von

2,34  Gt  des in Beispiel 1 beschriebenen Polyurethans,

2,34  Gt  eines Kondensationsprodukts aus 3-Methoxy-diphenylamin und Formaldehyd, hergestellt in 85%iger Phosphorsäure,

0,16  Gt  Phosphorsäure und

0,16  Gt  eines blauen Azofarbstoffs, erhalten durch Kuppeln von 2,4-Dinitro-6-chlor-benzoldiazoniumsalz mit 2-Methoxy-5-acetylamino-N-cyanoäthyl-N-hydroxyäthyl-anilin

95,00  Gt  Äthylenglykolmonomethyläther

wurde auf eine Platte aus anodisiertem Aluminium in solcher Menge aufgebracht, daß nach dem Trocknen eine Schichtdicke von 1 g/m² erhalten wurde. Nach 60 Sekunden Belichtung unter einer Metallhalogenidlampe von 5000 kW im Abstand von 130 cm wurde die Kopierschicht mit den in den Beispielen 1 und 2 angegebenen Entwicklern entwickelt. Die Entwicklung verlief außerordentlich und rückstandsfrei.

**Patentansprüche**

1. Zum Entwickeln von belichteten lichtempfindlichen, ein Diazoniumsalz-Polykondensationsprodukt und ein wasserunlösliches organisches Polymeres enthaltenden Kopierschichten bestimmte Entwicklerlösung, die aus einer gepufferten wäßrigen Lösung eines wasserlöslichen Polymeren, eines anionischen Netzmittels und eines mit Wasser mischbaren organischen Lösungsmittels besteht und deren pH im Bereich von 3 bis 9 liegt, dadurch gekennzeichnet, daß die Lösung 0,5 bis 15 Gew.-% anionisches Netzmittel, als wasserlösliches Polymeres 0,5 bis 6 Gew.-% Poly-N-vinyl-N-methyl-acetamid oder 1 bis 5 Gew.-% Polyvinylalkohol, 0,5 bis 6 Gew.-% eines den pH-Wert in dem angegebenen Bereich stabilisierenden Salzes oder Salzgemisches, von 0,5 Gew.-% bis zur Sättigungskonzentration Benzylalkohol und von 0,5 Gew.-% bis zur Sättigungskonzentration Glycerintriacetat enthält.

2. Entwicklerlösung nach Anspruch 1, dadurch gekennzeichnet, daß sie ein pH von 4 bis 8 hat.

3. Entwicklerlösung nach Anspruch 1, dadurch gekennzeichnet, daß sie zusätzlich 0,01 bis 2 Gew.-% Gelatine enthält.

4. Entwicklerlösung nach Anspruch 1, dadurch gekennzeichnet, daß sie zusätzlich 0,1 bis 2 Gew.-% eines mit Wasser begrenzt mischbaren organischen Lösungsmittels mit einem Siedepunkt oberhalb 120°C enthält.

5. Entwicklerlösung nach Anspruch 1, dadurch gekennzeichnet, daß sie zusätzlich 0,001 bis 0,1 Gew.-% eines mit den übrigen Bestandteilen verträglichen Oxydationsinhibitors enthält.

6. Entwicklerlösung nach Anspruch 1, dadurch gekennzeichnet, daß das den pH-Wert stabilisierende Salz bzw. Salzgemisch aus mindestens einem sauren Alkaliphosphat besteht.

7. Entwicklerlösung nach Anspruch 6, dadurch gekennzeichnet, daß sie zusätzliche Phosphorsäure in solcher Menge enthält, daß der pH-Wert in dem angegebenen Bereich liegt.

8. Entwicklerlösung nach Anspruch 1, dadurch gekennzeichnet, daß das anionische Netzmittel ein Salz eines Fettalkoholpolyoxyäthylensulfats ist.

9. Verfahren zum Entwickeln von lichtgehärteten Kopierschichten, die ein Diazoniumsalz-Polykondensationsprodukt und ein wasserunlösliches organisches Polymeres enthalten, dadurch gekennzeichnet, daß man sie mit einer Lösung nach einem der Ansprüche 1 bis 8 behandelt.

10. Verfahren zum Entwickeln von belichteten lichtempfindlichen Kopierschichten nach Anspruch 9, dadurch gekennzeichnet, daß man eine Kopierschicht verwendet, die zusätzliche Phosphorsäure enthält.

**Claims**

1. Developer solution for developing exposed, light-sensitive copying layers which contain a diazonium salt polycondensation product and a water-insoluble organic polymer, the developer solution comprising a buffered aqueous solution composed of a water-soluble polymer, an anionic wetting agent and an organic solvent which is miscible with water and having a pH in the range from 3 to 9, characterised in that the solution contains from 0.5 to 15 percent by weight of an anionic wetting agent, from 0.5 to 6 percent by weight of poly-N-vinyl-N-methyl-acetamide or from 1 to 5 percent by weight of polyvinyl alcohol, as a water-soluble polymer, from 0.5 to 6 percent by weight of a salt or salt mixture which stabilizes the pH value in the specified range, from 0.5 percent by weight up to saturation concentration of benzyl alcohol and from 0.5 percent by weight up to saturation concentration of glycerol triacetate.

2. A developer solution as claimed in claim 1, which has a pH in the range from 4 to 8.

3. A developer solution as claimed in claim 1, which additionally contains from 0.01 to 2 percent by weight of gelatin.

4. A developer solution as claimed in claim 1, which additionally contains from 0.1 to 2 percent by weight of an organic solvent which is, to a limited extent, miscible with water and has a boiling point above 120°C.

5. A developer solution as claimed in claim 1, which additionally contains from 0.001 to 0.1 percent by weight of an oxidation inhibitor which is compatible with the other constituents.

6. A developer solution as claimed in claim 1, wherein the salt or salt mixture which stabilizes the pH value comprises at least an acidic alkali metal phosphate.

7. A developer solution as claimed in claim 6, which additionally contains phosphoric acid in such a quantity that the pH value is within the given range.

8. A developer solution as claimed in claim 1, wherein the anionic wetting agent is a salt of a fatty alcohol polyoxyethylene sulfate.

9. Process for developing light-hardened copying layers which comprise a diazonium salt polycondensation product and a water-insoluble organic polymer, wherein the copying layers are treated with a solution according to any of claims 1 to 8.

10. A process for developing exposed, light-sensitive copying layers as claimed in claim 9, wherein a copying layer is used which additionally contains phosphoric acid.

**Revendications**

1. Révélateur pour le développement après leur exposition à la lumière de couches de reproduction photosensibles contenant un produit de polycondensation d'un scl de diazonium et un polymère organique insoluble dans l'eau, comprenant une solution aqueuse tamponnée d'un polymère hydrosoluble, d'un agent mouillant anionique et d'un solvant organique miscible à l'eau et dont le pH est compris entre 3 et 9, caractérisé en ce que ce révélateur contient entre 0,5 et 15% en poids d'un agent mouillant anionique, en tant que polymère hydrosoluble entre 0,5 et 6% en poids de poly-N-vinyl-N-méthylacétamide ou entre 1 et 5% en poids d'alcool polyvinylique, entre 0,5 et 6% en poids d'un sel ou d'un mélange de sels stabilisant le pH dans le domaine indiqué, entre 0,5% en poids et la concentration de saturation d'alcool benzylique et entre 0,5% en poids et la concentration de saturation de triacétate de glycérol.

2. Révélateur selon la revendication 1 caracérisé en ce qu'il présente un pH compris entre 4 et 8.

3. Révélateur selon la revendication 1, caractérisé en ce qu'il contient en outre entre 0,01 et 2% en poids de gélatine.

4. Révélateur selon la revendication 1, caractérisé en ce qu'il comprend en outre entre 0,1 et 2% en poids d'un solvant organique ayant une miscibilité limitée avec l'eau et dont le point d'ébullition est supérieur à 120°C.

5. Révélateur selon la revendication 1 caractérisé en ce qu'il contient en outre entre 0,001 et 0,1% en poids d'un inhibiteur d'oxydation compatible avec les autres ingrédients.

6. Révélateur selon la revendication 1, caractérisé en ce que le sel ou le mélange de sels stabilisant le pH comprend au moins un phosphate alcalin acide.

7. Révélateur selon la revendication 6, caractérisé en ce qu'il contient de l'acide phosphorique en une quantité telle que le pH se maintient dans le domaine indiqué.

8. Révélateur selon la revendication 1, caractérisé en ce que l'agent mouillant anionique est un sel d'un sulfate de polyoxyéthylène d'un alcool gras.

9. Procédé pour le développement de couches de reproduction durcies à la lumière, contenant un produit de polycondensation d'un sel de diazonium et un polymère organique insoluble dans l'eau, caractérisé en ce que l'on les traite avec un révélateur selon l'une quelconque des revendications 1 à 8.

10. Procédé pour le développement après leur exposition à la lumière de couches de reproduction selon la revendication 9, caractérisé en ce que l'on emploie une couche de reproduction contenant additionallement de l'acide phosphorique.